(19) **Europäisches Patentamt / European Patent Office / Office européen des brevets**

(11) **EP 2 317 562 A1**

(12) # EUROPEAN PATENT APPLICATION

(43) Date of publication:
**04.05.2011 Bulletin 2011/18**

(21) Application number: **09382238.5**

(22) Date of filing: **03.11.2009**

(51) Int Cl.:
*H01L 31/0224* (2006.01)    *H01L 31/18* (2006.01)
*G02F 1/1343* (2006.01)    *H01G 9/20* (2006.01)
*H05B 33/28* (2006.01)    *H01L 51/52* (2006.01)
*H01L 51/44* (2006.01)    *H01L 33/42* (2010.01)

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicants:
• **Fundacio Privada Institut De Ciencies Fotoniques**
**08860 Barcelona (ES)**
• **Institució Catalana de Recerca i Estudis Avançats**
**08010 Barcelona (ES)**

(72) Inventors:
• **Pruneri, Valerio**
**08860, CASTELLDEFELS (Barcelona) (ES)**
• **Ghosh, Dhriti, Sundar**
**08860, CASTELLDEFELS (Barcelona) (ES)**
• **Chen, Tong, Lai**
**08860, CASTELLDEFELS (Barcelona) (ES)**

(74) Representative: **Carpintero Lopez, Francisco et al**
**Herrero & Asociados, S.L.**
**Alcalá 35**
**28014 Madrid (ES)**

(54) **Multilayer metallic electrodes for optoelectronics**

(57)      The invention relates to an electrode comprising a substrate (1) and a layered structure comprising an electrically conductive film (2) in contact with at least one ultra thin metal film (3), wherein the two films (2,3) are of different materials and

- said electrically conductive film (2) is selected from Cu, Au, Ag, Al
- said ultra thin metal film (3) is selected from Ni, Cr, Ti, Pt, Ag, Au, Al and their mixtures. The electrode is particularly useful for optoelectronic devices and shows good conductivity, transparency and stability.

Fig. 1

EP 2 317 562 A1

Printed by Jouve, 75001 PARIS (FR)

Description

## FIELD OF THE INVENTION

The present invention relates to electrodes comprising ultra thin metal films, suitable for diverse optoelectronic applications.

## BACKGROUND OF THE INVENTION

Transparent electrodes, i.e. films which can conduct electricity and at the same time transmit light, are of crucial importance for many optical devices, such as photovoltaic cells [Claes G. Granqvist "Transparent conductors as solar energy materials: A panoramic review" Solar Energy Materials & Solar Cells 91 (2007) 1529-1598], organic light emitting diodes [Ullrich Mitschke and Peter BaÈuerle, "The electroluminescence of organic materials" J. Mater. Chem., 2000, 10, 1471], integrated electro-optic modulators [CM Lee et al., " Minimizing DC drift in LiNbO3 waveguide devices", Applied Physics Lett. 47, 211 (1985)], laser displays [C.A. Smith "A review of liquid crystal display technologies, electronic interconnection and failure analysis Circuit" World Volume 34 Number 1 2008 35-41], photo-detectors, [Yu-Zung Chiou and Jing-Jou TANG "GaN Photodetectors with Transparent Indium Tin Oxide Electrodes" Japanese Journal of Applied Physics Vol. 43, No. 7A, 2004, pp. 4146-4149], etc.. From an application point of view, besides large optical transparency in the wavelength range of interest and adequate electrical conductivity, transparent electrodes should possess other key features, such as easy processing (e.g. possibility for large scale deposition), compatibility with other materials that form the same device (e.g. active layers), stability against temperature, mechanical and chemical stress, and low cost.
So far, transparent electrodes have been mainly fabricated using Transparent Conductive Oxides (TCOs), i.e. wide band gap semiconductors with heavy doping. Among them, Indium Tin Oxide (ITO) is the most widely used. Despite possessing large electrical conductivity and optical transparency from the visible to the infrared, TCOs present several drawbacks such as the requirement of high temperature (several hundreds of $\underline{o}$C) post deposition treatments to improve mainly their electrical properties, their strong electrical and optical dependence on the doping control and their multicomponent structure that can lead to incompatibilities with some active materials. In addition they are not transparent in the UV range, which might be relevant for several applications. Often, such as in the case of ITO, they are made of elements (In) which are not easily available in large quantities and thus expensive.
Recently there has been some interest of combining the TCO technology with metals to improve their properties such as lowering of square resistance and cost without a significant decrease in optical transmission. But complicated and high cost fabrication and incompatibility of the oxide with the metal, among other drawbacks, are still open questions.
In this sense Cu films have been proposed in combination with transparent oxides, either conductive (e.g. ITO) or insulating (e.g. ZnO) to form highly transparent and low sheet resistance multilayer transparent electrodes. One example is ZnO/Cu/ZnO [K. Sivaramakrishnan et al. Applied Phys Lett. 94 052104 (2009)] where average transmission in the visible of about 75% and sheet resistance of about 8 Ω/□ were achieved. ZnO/Cu/ZnO films are unstable since their optical and electrical properties change over time, in particular when annealed with temperature in different type of atmosphere, including ambient air. These changes are attributed to oxidation of Cu, change in surface morphology of the interface and difussion of Cu into ZnO [D.R. Sahu et al. Applied Surface Science 253, 827-832 (2006); D.R. Sahu et al. Applied Surface Science 253, 915-918 (2006); D.R. Sahu et al. Thin Solid Films 516, 208-211, (2007)]. Another example of multilayer transparent electrode using Cu is Cu on ITO. However also in this case the electrical and optical properties of the film change and this is attributed to diffusion of Cu into ITO [Tien-Chai Lin et al. Materials Science and Engineering B 129 (2006) 39-42]. Contrary to ZnO, the use of ITO would be expensive and leave the problem of In shortage unsolved.
These shortcomings led to search for alternatives of TCOs such as single walled carbon nanotubes (SWNTs), graphene films and ultrathin metal films (UTMFs). Transparent conductors based on low cost ultrathin metals have been previously reported [D.S. Gosh et al. Opt. Lett., 34, 325, (2009)]. Their competitiveness in real time devices has already been proved despite their relatively low transmission and high surface roughness with respect to ITO [D. Krautz et al. Nanotechnology, 20, 275204 (2009)].
In view of all above stated there is still the need in the state of the art to provide an alternative electrode for use in opto-electronic devices that presents both the required stability and the appropriate work function, while assuring a large optical transparency and high electrical conductivity.

## BRIEF DESCRIPTION OF THE FIGURES

Figure 1: represents a cross sectional view of an electrode consisting of an electrically conductive film (E) in contact with the substrate and a functional metal film (FMF).

**Figure 2**: represents a cross sectional view of an electrode consisting of a functional metal film (FMF) in contact with the substrate and an electrically conductive film (E).

**Figure 3**: represents a cross sectional view of an electrode consisting of a multilayer structure of two FMF films and an E film on a substrate.

**Figure 4**: represents a cross sectional view of an electrode consisting of a bilayered structure on a substrate, wherein the electrically conductive film (E) is in contact with the substrate, and an additional oxide film.

**Figure 5**: represents a cross sectional view of an electrode consisting of a bilayered structure on a substrate; an additional functional metal film and an additional oxide film.

**Figure 6**: represents a cross sectional view of an electrode consisting of a bilayered structure; an additional functional metal film and two additional oxide films.

**Figure 7**: represents the visible optical transparency (VOT) in the visible wavelengths against electrical sheet resistance of Cu, Cu+Ni1, Cu+Ti1 and Cu+Ti3_O$_2$ treated.

**Figure 8**: represents the optical transparency against wavelength (nm) for Cu+Ti of the different thicknesses indicated.

**Figure 9**: represents the change of optical transparency against wavelength (nm) of Cu 8 nm film as deposited and after annealing treatment.

**Figure 10**: represents change of optical transparency against wavelength (nm) of Cu+Ni_7+1 nm film as deposited and after annealing treatment.

**Figure 11**: represents the Figure of merit ($\Phi_{TC}$) for different sets of samples. $R_s t^3$ versus thickness (t) for determination of percolation threshold (inset).

**Figure 12**: represents the transparency spectrum of Cu6.5, Cu6.5+Ni1, Cu6.5+Ti1, and Cu6.5+T13_O$_2$ treated in the wavelength range of 400-1 000nm.

**Figure 13**: represents the absorption and reflection of Cu6.5, Cu6.5+Ni1, Cu6.5+Ti1, and Cu6.5+T13_O$_2$ treated. The values are the average between 375 nm and 700 nm. Inset shows spectrum of Cu6.5+Ni1 ultrathin film before (solid line) and after the annealing treatment (dashed line).

**Figure 14**: represents change of optical transparency against wavelength (nm) of Cu6.5+T15_O$_2$ treated film as deposited and after annealing treatment.

## DESCRIPTION OF THE INVENTION

In accordance with the invention, an electrode is provided which comprises a substrate and a layered structure comprising an electrically conductive film (2) in contact with at least one ultra thin metal film, (3) wherein the two films are of different materials and

-    said electrically conductive film is selected from Cu, Au, Ag, Al
-    said ultra thin metal film is selected from Ni, Cr, Ti, Pt, Ag, Au, Al and their mixtures.

Preferred embodiments of the invention are defined in the dependent claims.

In the context of the present invention an ultra thin metal film (UTMF) presents a thickness of less than or equal to 6 nm and can be obtained as explained below. According to the present invention electrically conducting films of a metal with a thickness typically in the range of 3 to 20 nm are useful for transparent electrodes. The term optically transparent as used in the present application refers to a transmission of more than 40% of the light in the wavelength range of interest which depends on the application. For example for visible OLEDs the range is between 375 and 700 nm, for UV photodetectors between 100 and 400 nm, for photovoltaic cells between 350 and 800 nm, for mid-infrared detectors between 3 and 25 μm, etc.

Cu is an inexpensive material with excellent electrical and optical properties which is already widely used in microelectronics. However Cu is known to be subjected to oxidation and corrosion, which alter significantly its electrical and optical properties. This disadvantage is solved by the use of an ultra thin metal film to cover the Cu electrically conductive film.

Different materials than Cu may be selected for the electrically conductive film, as they have very similar electrical properties and show a similar behaviour in electro optical applications and can be deposited in the form of thin metallic transparent films. These include Au, Ag and Al. properties

Ag, as the material for the electrically conductive film, is not totally stable and deteriorates. The ultra thin metal film in this case protects the Ag. Ag is inert and presents thus the further advantage that it does not affect properties of other materials present in the optoelectronic device, such as an active material. Ni for instance as an ultra thin metal film can improve the work function of the electrode with Ag.and protect it.

Au as the material for the electrically conductive film is stable and inert and does not generate any problems to active materials. In this case the ultra thin metal film in contact with the Au film has the advantage of adapting the work function of the corresponding electrode and optoelectronic device.

Al as the material for the electrically conductive film is similar to Ag and the ultrathin metal film in this case has the properties of protecting it or tuning its work function or both.

In a preferred embodiment the electrically conductive film is Cu, made of pure Cu (more than 99%). For instance Cu with at least an ultra thin metal film is suitable as an anode (high work function) or as a cathode (low work function) in a light emitting diode.

The UMTF can be prepared by deposition of a continuous UTMF on a layer of the electrode of the invention, wherein said layer can be the substrate (i) of the electrode of the present invention, the electrically conductive film, the active material of a device or an oxide film. Said deposition is advantageously performed by sputtering deposition under vacuum as already mentioned above for the electrically conductive film. The UTMF can be advantageously prepared at room temperature and it is technologically compatible with all organic and semiconductor materials such as the active medium layers in organic devices. The starting surface roughness of the film or layer on which the UTMF is prepared should preferably be below the thickness of the film; otherwise said UTMF could be discontinuous and thus non-conductive. It is possible to deposit continuous UTMFs on surfaces with a roughness equal to or larger than the thickness of the film when such roughness refers to surface peak-to-valley distances much larger than the film thickness. According to a preferred embodiment the UTMF is Ni or Ti, but other materials like Cr, Au, Pt can be used. All these material can be deposited in the required thickness to put in place this invention and present high level of stability. In addition they are compatible with other materials forming the devices and have different work function which can be tailored to a specific application. Other materials, such as Ag and Al, could be used for their relatively low work function and also to increase stability (for protection) when the electrically conductive film is Cu.

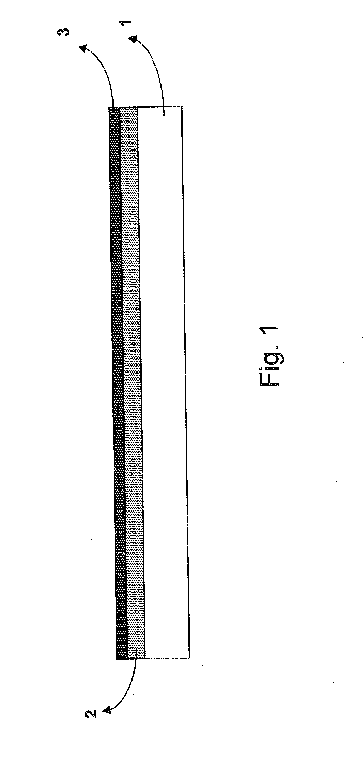

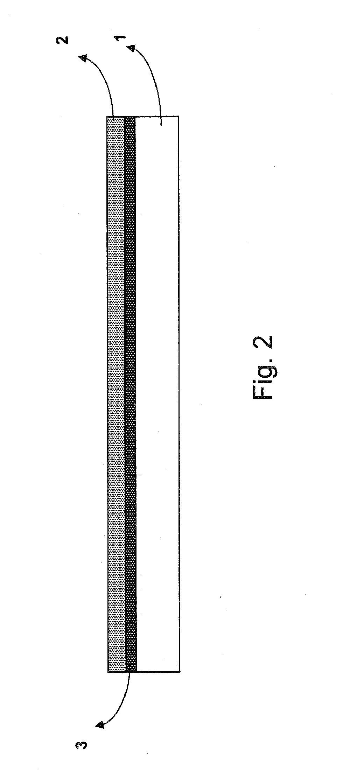

According to a particular embodiment of the invention shown in figure 1, the electrically conductive film (2) of the bilayered-structure is in contact with the substrate (1). According to another particular embodiment of the invention shown in figure 2, the UTMF (3) is in contact with the substrate.

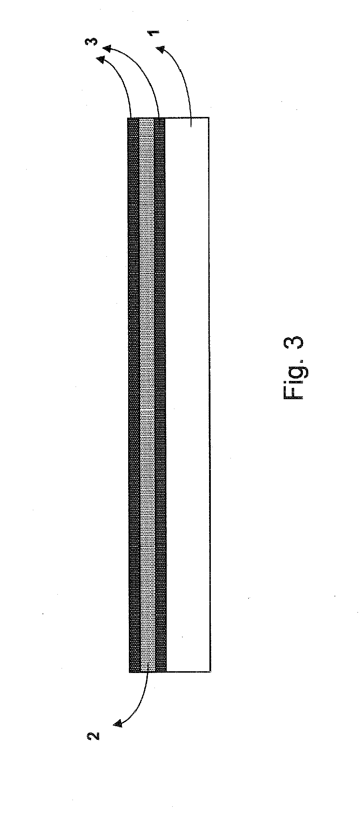

The electrode of the invention can besides present among others the structures illustrated in Figures 3 to 6. Thus, in one embodiment, the electrically conductive film is deposited onto the substrate of the electrode of the invention. According to another embodiment of the invention the film is deposited onto the UTMF film

The substrate of the electrode of the invention can be of any suitable dielectric material on which the bilayered structure is grown upon, such as glass, a semiconductor, an inorganic crystal, a rigid or flexible plastic material. Illustrative examples are silica ($SiO_2$), borosilicate (BK7), silicon (Si), lithium niobate ($LiNbO_3$), polyethylen naphthalate (PEN), polyethelene terephthalate (PET), among others. Said substrate can be part of an optoelectronic device structure, e.g. an active semiconductor or organic layer.

The electrically conductive film can be obtained by any method well known in the art, such as deposition on an adjacent film or layer of the electrode of the invention. The deposition of films according to the present invention is advantageously performed among the possible deposition techniques by sputtering under vacuum, which may be carried out in a conventional magnetron sputtering machine (Ajaint Orion 3 DC). In a particular embodiment, the deposition is carried out at room temperature and in pure inert atmosphere (like Argon) using DC or RF sputtering. The starting surface roughness of the layer on which a film is deposited, such as the substrate on which the electrically conductive film is prepared, should preferably be below the thickness of the film to be deposited; otherwise said electrically conductive film could be discontinuous and thus non-conductive. It is possible to deposit continuous electrically conductive films on surfaces with a roughness equal to or larger than the thickness of the film when such roughness refers to surface peak-to-valley distances much larger than the film thickness.

For the purpose of this invention the continuity is mandatory for the electrical conductive film while it is preferable, though not necessary, for the ultrathin metal film.

According to a particular embodiment of the invention shown in figure 3 the electrode comprises a further ultra thin metal film (3) in contact with the electrically conductive film (2) of the bilayered structure, wherein this second UTMF is selected from nickel, chromium, gold, silver, titanium, calcium, platinum, magnesium, aluminium, tin, indium, zinc and their mixtures, and can be the same as the first UMTF.

In a particular embodiment of the invention the UTMF of the electrode is optionally passivated. The passivation treatment is carried out according to the method disclosed in patent application No. EP 08157959 to produce a stable UTMF which comprises thermally treating the deposited UTMF in ambient atmosphere or optionally in the presence of an oxygen enriched atmosphere. A protective oxide film is achieved on top of the UTMF. Generally said oxide layer presents a thickness typically comprised between 0.1 and 5 nm. The UTMF appropriately oxidized, increases the stability of the underlying electrically conductive film.

According to another particular embodiment of the invention the electrode comprises further at least one grid or mesh in contact with the electrically conductive film or in contact with a functional metal film. Said grid or mesh comprises openings and can be obtained according to the method described in patent application EP 09382079. In this sense it can be prepared in several ways depending on the metal and dimensions of the structure, for instance, by UV lithography, soft lithography (nano-imprinting), screen printing or by a shadow mask depending on the geometrical constraints, or by deposition which may rely on techniques similar to those used for UTMF layer or other thicker layers, such as evaporation or electroplating. All these techniques are well known to the person skilled in the art. The UTMF can be as above mentioned optionally passivated before or after the deposition of the grid or mesh. Said grid or mesh can comprise Ni, Cr, Ti, Al, Cu, Ag, Au, doped ZnO, doped $SnO_2$ doped $TiO_2$ carbon nanotubes or Ag nanowires or a mixture thereof, being of the same or different material as the FMF or the electrically conductive film. The period and the thickness of the grid, when this consists of a periodic metallic structure, can typically range from 500 nm to 1 mm and 10 nm to 1 $\mu$m, respectively, for the purpose of this invention. In fact the geometrical dimensions of the grid or mesh depend on the material is made of and on the application of the electrode of the invention, as well as on the thickness of the underneath electrically conductive film or UTMF and the local current densities involved.

Preferably, the fill factor of the metal grid or mesh when this is opaque is not more than 5%. Optionally the grid has a square, rectangular like pattern, periodic or in the form of a random mesh.

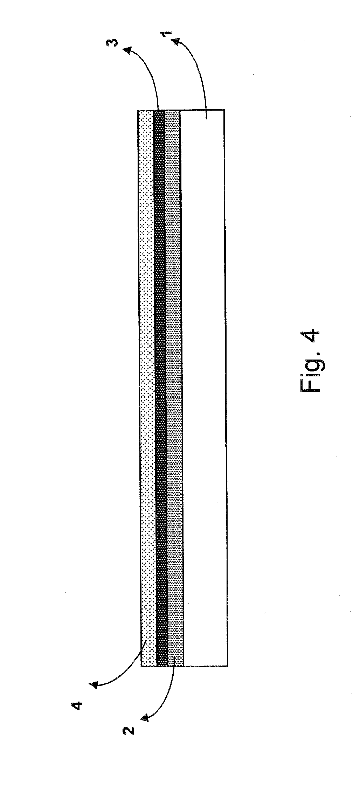

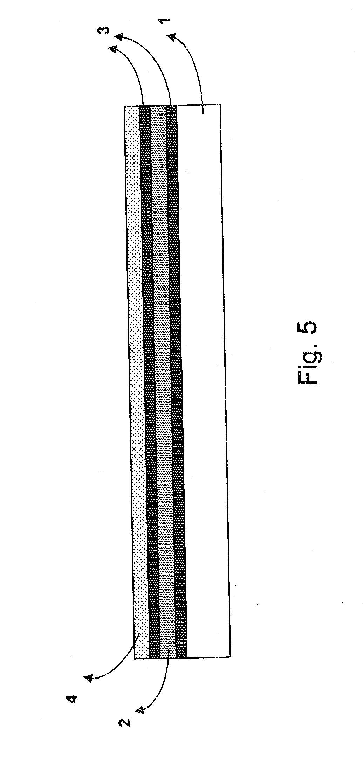

In other embodiments of the present invention shown in figures 4 and 5, the electrode comprises further at least an oxide film (4) in contact with a UTMF film wherein said oxide is selected from the group of

(i) nickel oxides, copper oxides, chromium oxides, titanium oxides, Ta or Nb doped titanium oxide, calcium oxides, magnesium oxides, aluminium oxide, tin oxides, F doped tin oxide, indium oxides, zinc oxides, Al or Ga doped zinc oxide, ITO, and their mixtures, or from the group of
(ii) Ni, Cr, Au, Ag, Ti, Ca, Pt, Mg, Al, Sn, In, Zn and their mixtures.

When the oxide film is selected from group (i) above, it can be optionally obtained by oxidation of the UTMF or for instance by direct deposition from their corresponding oxide bulk materials.

Alternatively, when the oxide film is a metal: nickel, chromium, gold, silver, titanium, calcium, platinum, magnesium, aluminium, tin, indium, zinc or their mixtures, the oxide film can be obtained by sputtering, evaporation and other deposition techniques known to a person skilled in the art.

Oxide films are typically in the range from 2 to 200 nm thickness.

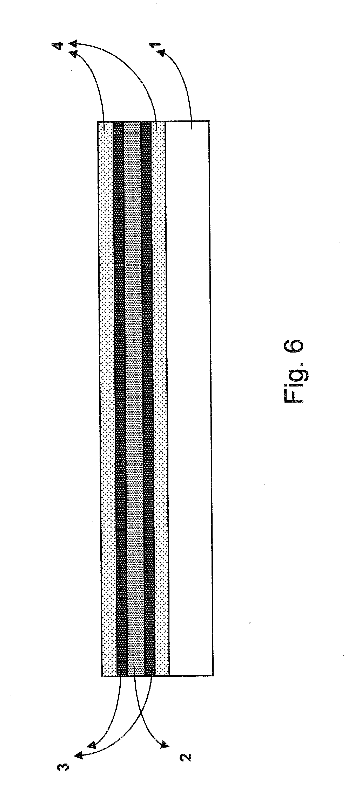

In a particular embodiment of the electrode of the invention, the electrode comprises a UTMF on each side of the conductive layer and two oxide films (4), which can be the same or different, each in contact with a UTMF (see figure 6).

The transparency and electrical sheet resistance of a Cu electrically conductive film are in the range for practical application (> 70%, < 50 Ω/sq).

According to a particular embodiment of the invention, the electrode of the invention is transparent having a 3 to 20 nm thick Cu electrically conductive film, preferably between 4 and 10 nm and more preferably between 5.5 and 6.5 nm Cu, which is the percolation thickness of the film below which the film structure looks like disconnected islands and above which the film is continuous and conductive.

In a particular embodiment, a Cu film of thickness between 4 and 10 nm is provided with Ti as the UTMF with a thickness of between 3 to 5 nm. Preferably said Ti film has been $O_2$ treated. Also preferably the $O_2$ treated Ti functional metal film has been annealed (for instance 1 hour at 120°C). More advantageously the Cu film is between 6.5-6.6 nm. Said electrodes can present a sheet resistance <30 Ω/□ and peak transparency exceeding 80%.

Also preferred is a Cu film of thickness between 4 and 10 nm and a 1 -3 nm thick Ni UTMF. More advantageously the Cu film is between 6.5-6.6 nm. Said Ni UTMF can have been annealed (for instance 1 hour at 120°C), showing extremely high heat-resistance properties, which can stabilize the Cu film, maintain the square resistance and slightly improve the optical transparency. These electrodes are useful in harsh environment device applications.

According to another preferred embodiment the electrode is a transparent electrode having a Cu electrically conductive film, a FMF, and at least an oxide film in the range of 5 to 200 nm.

In the following, unless otherwise stated, the visible optical transparency (VOT) is an average value over the 375 to 700 nm range where the substrate contribution has been subtracted. In the figures the first and the second numbers are respectively the Cu and the UTMF thicknesses.

The inventors have shown the following:

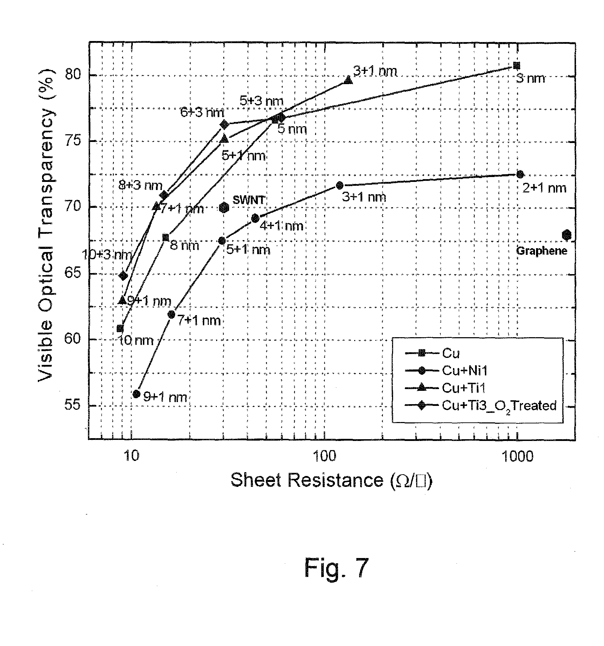

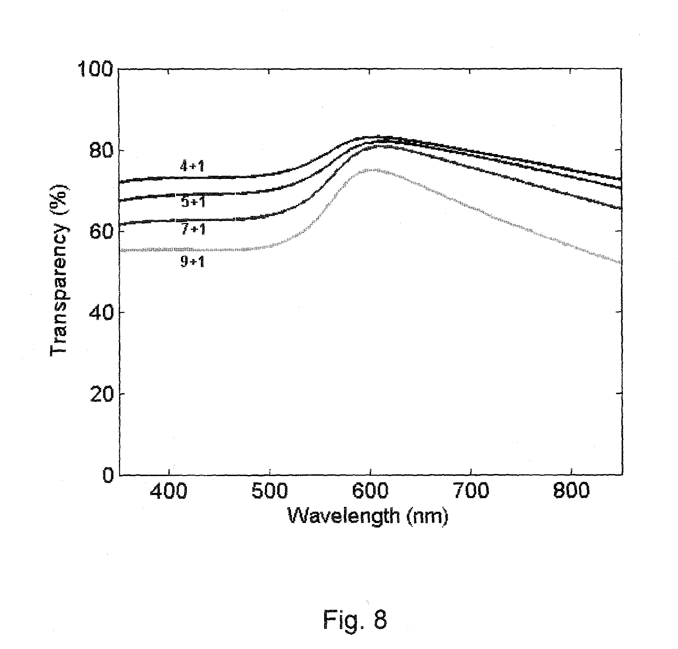

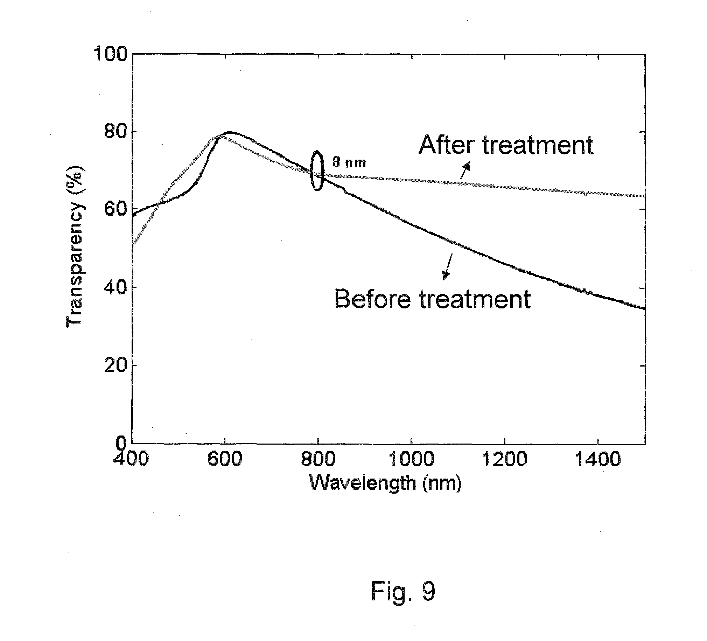

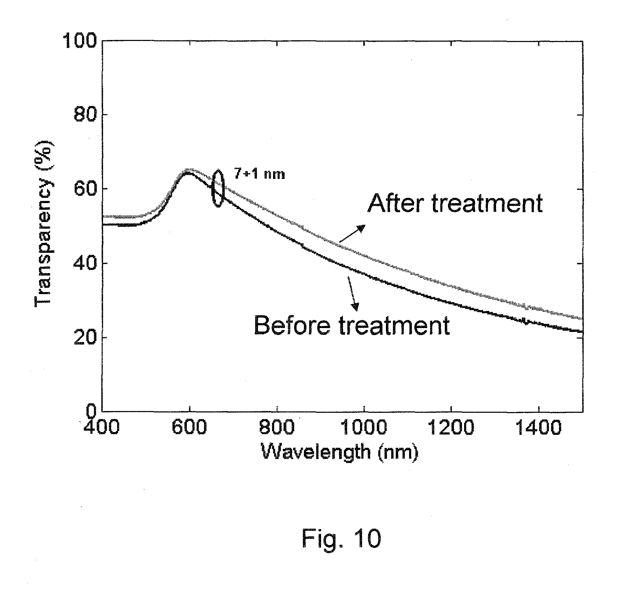

When a UTMF is used together with a Cu film forming the bilayered structure of the invention, the electrical and optical performance of the Cu film is basically maintained (figures 7 and 8). In Figure 7 the visible optical transparency (VOT) is represented against the electrical sheet resistance (Ω/sq). In fact the use of Ni-UTMF for example increases the work function and makes the transparent electrode (TE) more suitable as anode for OLEDs. In Figure 8 transparency is represented against the wavelength (nm). The inventors have also shown that the exposure to high temperature degrades the optical and electrical performance of Cu films but not of bilayered structures Cu+FMF, such as Cu+Ni_ 7+1 as shown in figures 9 and 10, and in the following Table 1.

Table 1: electrical and optical properties of as deposited and thermally treated films in ambient atmosphere

|  | As deposited | | After annealing at 120°C for 1 h | |
|---|---|---|---|---|
|  | Rs | VOT | Rs | VOT |
| Cu_8nm | 15 | 67.74 | Not measurable | 73.2 |
| Cu + Ni-7+1 | 16.08 | 61.93 | 17.05 | 62.03 |

In fact it has been shown that after annealing at 120°C for 1 hour, the sheet resistance of Cu (Cu_8 nm film) cannot be measured any longer and its transparency changes significantly (figure 9). On the other hand after annealing, Cu+Ni (Cu+Ni-7+1 nm film) keeps the same resistance and is actually slightly more transparent over the whole wavelength range (fig. 10).

In Figure 7 the performances of electrodes according to the invention comprising a bilayered structure (Cu-Ni/Ti) alongside SWNT and graphene film are compared. It can be seen that the 1 nm Ni-FMF reduces the transmission by about 10 % while the Ti-FMF increases it without any significant change in square resistance. This behaviour can be explained in terms of refractive index matching and extinction coefficient discrepancy of Ni and Ti ultrathin films. Ultrathin Ti film has lower refractive index and much smaller extinction coefficient compared to those of Ni film, and thus leads to less absorption and interface reflection. In a real ultrathin metal film, theoretical models for resistivity do not work very well, because besides geometrical limitation (size-effect) that enhances surface scattering, the resistivity also depends on volume sources of scattering, such as grain boundaries, voids and discontinuities, which in return is very sensitive to deposition conditions. Therefore, the deposition conditions for which the films have lowest square resistance may be optimized. It is observed that the conductivity behaviour for these four sets of samples is mainly dominated by underlying Cu electrically conductive ultrathin film, when this film becomes continuous (>5 nm).

The $O_2$ treatment on Cu+Ti3 oxidizes only the top few nanometers of Ti without disturbing the interface between Cu and Ti. The formation of Ti oxide not only protects the underlying Cu layer from oxidation but also increases the transmission. The peak transparency and square resistance for Cu6+Ti3_$O_2$ Treated sample is >86 % at 630 nm and 30Ω/□, respectively. These results are much better than what has been reported for Ni ultrathin metal films. However, similar efficiencies were reached for devices with either ITO or Ni ultrathin metal films as the bottom electrode where high work function of Ni played an important role. With appropriately choosing the UTMF, and if necessary oxidizing it, the work function of the transparent conductor can be tuned according to device configuration. In addition, it is clear from figure 7 that ultrathin Cu based transparent conductors are rather better than SWNTs and graphene films which are now considered as potential candidates to replace TCOs.

To compare the performance of different sets of transparent conductors the figure of merit, $\Phi_{TC}$ defined by Haacke was calculated:

$$\Phi_{TC} = \frac{T^{10}}{R_S}$$

where T is the average optical visible transparency from 375 to 700 nm and $R_s$ is the square resistance.

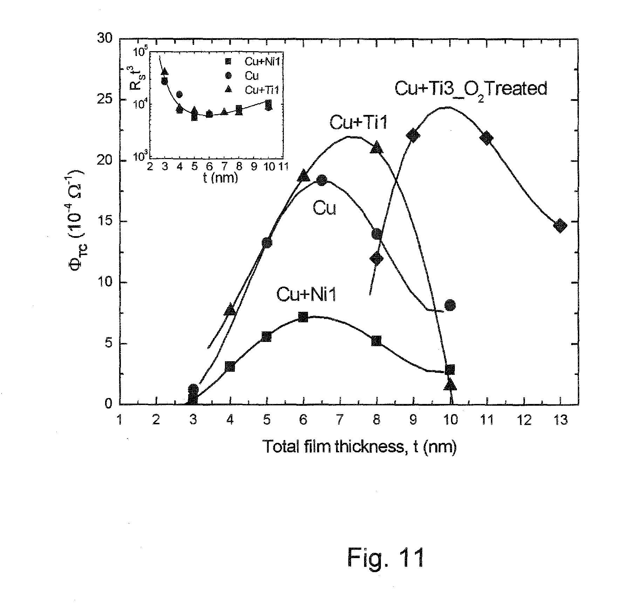

Figure 11 shows the figure of merit for the different sets of samples. The Cu+Ti3_O2 treated samples present a peak value of $\Phi_{TC}$ equal to 2.5 x $10^{-3}$ $\Omega^{-1}$. For all the data sets the best figure of merit is obtained for Cu thickness between 5.5 and 6.5 nm which indicates that Cu becomes continuous in this range. To further confirm this, the percolation threshold was estimated by plotting $R_s t^3$ versus t (where t stands for the film thickness) 15 for the different sets of samples (inset of fig. 11). The percolation thresholds for all the sets are found to be between 5.5 nm and 6.5 nm, which reassert the inventor's prediction above. One sample was deposited for each set with fixed Cu thickness of 6.5 nm which is defined from percolation thickness (inset of fig. 11). The RMS roughness for all the four samples measured by AFM shows peak-to-valley values much less than the films thickness.

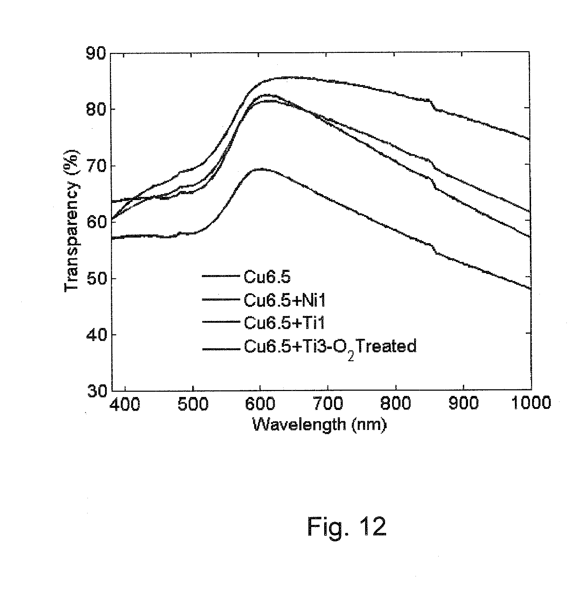

Figure 12 shows the transparency spectrum for all these samples. The different optical transmission behaviours in visible-light region can be explained in terms of reflection and absorption.

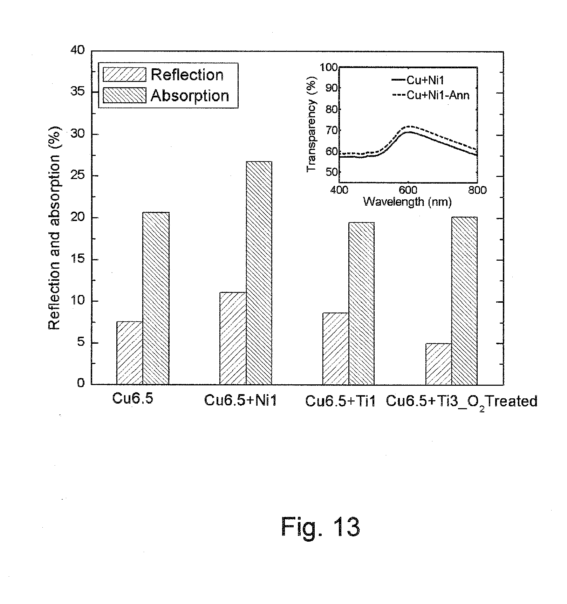

Figure 13 compares the average reflection and absorption of all these four samples in the visible-light region. The absorption were calculated using A=1-(T+R). It is observed that except Ni-FMF all other samples show similar absorption but interestingly the in-situ $O_2$ plasma treated sample has less reflection which accounts for its high transmission. Ni-FMF shows higher reflection as well as higher absorption, which results in lower transmission compared to other three samples. To evaluate the stability of the samples, these were kept in oven for 60 min at 120 ºC in atmosphere ambient. Unlike other three samples which show hike in transparency accompanied by increase in square resistance after the heat treatment, the square resistance and visible-light transparency of Cu6.5+Ni1 are found to be little influenced and actually slightly improved. It is clear that mere 1 nm Ni FMF fully protects the underlying Cu from oxidation in harsh environment. The inset of figure 13 shows the visible-light region spectrum of Cu6.5+Ni1 before (solid line) and after the heat treatment (dashed line). The tiny improvement both in electrical and optical properties might be due to the improved interface crystallinity.

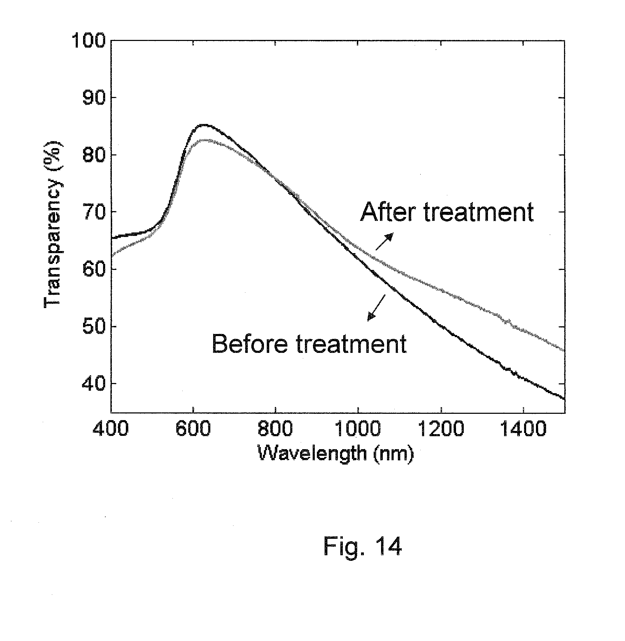

Figure 14 compares the transparency of $O_2$ treated Cu 6.5nm+Ti 5nm as deposited and after annealing for 60 min at 120 oC in atmosphere ambient. From the graph it is evident that the annealing treatment does not change significantly the transparency of the films in the visible range. The square resistance of the films increased only slightly with the annealing (from 15.9 to 19.8 $\Omega/\square$). It is thus clear that 5 nm oxidised Ti FMF practically protects the underlying Cu from oxidation in harsh environment.

Table 2: electrical and optical properties of $O_2$ treated films before and after thermal treatment (annealing) in ambient atmosphere

|  | $O_2$ treated | | After annealing at 120oC for 1 h | |
| --- | --- | --- | --- | --- |
|  | Rs | VOT | Rs | VOT |
| Cu + Ti_6.5+5 | 15.9 | 74.24 | 19.8 | 72.33 |

In conclusion, cheaper, easy-to-fabricate, stable electrodes comprising an electrically conductive metal film and a UTMF are suitable transparent conductors for various optoelectronic applications. Electrodes of the present invention show average transparency as high as 75% in visible-light range and square resistance as low as 20 $\Omega/\square$. The figure of merit $\Phi_{TC}$ of Cu based bilayered electrodes is found to be rather better than SWNT and graphene films. The Cu+Ni1 and $O_2$ treated Cu+Ti5 samples show excellent stability even after a heat treatment in oven for 60 min at 120 oC in atmosphere ambient.

The inventors have achieved exploiting the electrical and optical properties of materials, in particular Cu, or other similar electrically conductive materials, without the shortcomings of existing electrodes of the state of the art. In this sense the electrodes of the invention are stable and transparent conductive electrodes which find many applications due to their simple and low cost structure and method of fabrication and their intrinsic technical characteristics. The stability of the electrodes is of outmost importance to maintain the performance of the devices over time, in particular under demanding and changing environmental conditions. The transparent electrodes of the invention can thus be used in a wide variety of devices.

In another aspect the invention relates to an opto-electronic device which comprises at least an electrode as above defined. Said device can be a light emitting diode (LED), an organic light emitting diode (OLED), a display, a photovoltaic cell, an optical detector, an optical modulator, an electro-chromic device, an E-paper, a touch-screen, an electromagnetic shielding layer, and a transparent or smart (e.g. energy saving, defrosting) window, etc.

The foregoing is illustrative of the present invention. This invention however is not limited to the following precise embodiment described herein, but encompasses all equivalent modifications within the scope of the claims which follow.

## EXAMPLE

Electrodes according to the invention corresponding to the embodiment illustrated in Figure 1 were obtained. Optically double sided polished UV fused silica substrates were first cleaned each with acetone and ethanol for 10 minutes in ultrasonic bath and then dried with nitrogen gun. The clean substrates were then loaded in the main chamber of the sputtering system (Ajaint Orion 3 DC) with pressure levels down to the order of $1.33 \times 10^{-6}$ Pa ($10^{-8}$ Torr) The sputtering was performed at room temperature in a pure argon atmosphere of 0.226 Pa (2 mTorr) and 100 W DC power. The target has the purity levels of 99.99%. Prior to the deposition the substrate was again cleaned with oxygen plasma with base pressure of 1.06 Pa (8mTorr) and 40 W RF power for 15 minutes.

Cu and Ni were deposited using DC sputtering while Ti was fabricated with RF sputtering. The thicknesses were monitored by MCM-160 quartz crystal. The deposition rates were determined as 1.5 Å/s for Cu, 0.573 Å/s for Ni and 0.083 Å/s for Ti. In these electrodes the electrically conductive film was Cu with thicknesses between 3-10 nm and the functional metal film was Ni or Ti with thicknesses between 1 nm and 5 nm.

In particular four different sets of varied Cu thickness were fabricated, viz. Cu, 1 nm Ni on Cu, 1 nm Ti on Cu, 3 nm Ti on Cu, 5 nm Ti on Cu and hereafter will be abbreviated as Cu, Cu+Ni1, Cu+Ti1, Cu+Ti3, and Cu+Ti5 respectively. The 3 and 5 nm Ti on Cu were then in situ oxidized for 15 minutes using $O_2$ plasma with working pressure of 8mT and 40 W RF power (hereafter, abbreviated as $O_2$ Treated).

Perkin Elmer lambda 950 spectrometer was used for the transmission spectra measurements while Cascade Microtech 44/7 S 2749 four-point probe system and Keithley 2001 multimeter for square resistance measurements. The fabricated films were characterized by Atomic Force Microscopy (AFM) with a digital instrument D3100 AFM and associated software WsXM.

## Claims

1. An electrode comprising a substrate (1) and a layered structure comprising an electrically conductive film (2) in contact with at least one ultra thin metal film, (3) wherein the two films are of different materials and

    - said electrically conductive film is selected from Cu, Au, Ag, Al
    - said ultra thin metal film is selected from Ni, Cr, Ti, Pt, Ag, Au, Al and their mixtures.

2. An electrode according to claim 1 wherein the electrically conductive film and/or the ultra thin metal film are optically transparent.

3. An electrode according to any of the preceding claims wherein ultra thin metal film has been treated thermally in ambient atmosphere or in the presence of an $O_2$ enriched atmosphere.

4. An electrode according to any one of the preceding claims further comprising a metal grid or mesh made on the layered structure.

5. An electrode according to any of the preceding claims, wherein the electrically conductive film is Cu.

6. An electrode according to claim 5, wherein the ultra thin metal film is Ni.

7. An electrode according to claim 5 wherein the ultra thin metal film is Ti.

8. An electrode according to claim 6, wherein the Cu film is between 4 to 10 nm thick and the Ni ultra thin metal film has a thickness of between 1 and 3 nm.

9. An electrode according to claim 7, wherein the Cu film is between 4 to 10 nm thick and the Ti ultra thin metal film has a thickness of between 3 and 5 nm.

10. An electrode according to any of the preceding claims comprising only one ultra thin metal film and wherein the electrically conductive film is closer to the substrate.

11. An electrode according to any of claims 1-9 comprising only one ultra thin metal film and wherein the ultra thin metal film is closer to the substrate.

12. An electrode according to any of the preceding claims further comprising at least an oxide film (4) in contact with at least one ultra thin metal film, wherein said oxide is selected from the group of

    (i) nickel oxides, copper oxides, chromium oxides, titanium oxides, Ta or Nb doped titanium oxide, calcium oxides, magnesium oxides, aluminium oxide, tin oxides, F doped tin oxide, indium oxides, zinc oxides, Al or Ga doped zinc oxide, ITO, and their mixtures, or from the group of
    (ii) Ni, Cr, Au, Ag, Ti, Ca, Pt, Mg, Al, Sn, In, Zn and their mixtures.

13. An optoelectronic device comprising at least one electrode according to any of the preceding claims.

Fig. 1

Fig. 2

Fig. 3

Fig. 4

Fig. 5

Fig. 6

EP 2 317 562 A1

Fig. 7

Fig. 8

Fig. 9

EP 2 317 562 A1

Fig. 10

Fig. 11

Fig. 12

Fig. 13

Fig. 14

Europäisches
Patentamt

European
Patent Office

Office européen
des brevets

**EUROPEAN SEARCH REPORT**

Application Number

EP 09 38 2238

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 184 964 B1 (KAMEYAMA MAKOTO [JP] ET AL) 6 February 2001 (2001-02-06)<br>* abstract *<br>* column 3, lines 10-46 *<br>* column 6, lines 7-42 *<br>* column 7, lines 5-51 *<br>* column 8, line 50 - column 9, line 43 *<br>* column 10, lines 21-35 *<br>* column 13, lines 53-61 *<br>* column 15, lines 11-33 *<br>* column 16, lines 7-13 *<br>* column 18, lines 15-24 *<br>* column 19, lines 47-57; figures 1-4,6,15,16 * | 1-3,5-7, 10-13 | INV.<br>H01L31/0224<br>H01L31/18<br>G02F1/1343<br>H01G9/20<br>H05B33/28<br>H01L51/52<br>H01L51/44<br>H01L33/42 |
| X | US 6 825 409 B2 (HAUSSLER WULF [DE] ET AL) 30 November 2004 (2004-11-30)<br>* column 1, lines 28-42 *<br>* column 2, lines 31-46 *<br>* column 3, lines 12-33 *<br>* column 4, lines 1-10 *<br>* column 4, lines 15-31 *<br>* claims 1,9 * | 1-13 | |
| A | US 2003/165693 A1 (HARTIG KLAUS [US] ET AL) 4 September 2003 (2003-09-04)<br>* paragraphs [0002] - [0008] *<br>* paragraphs [0055] - [0057] *<br>* paragraphs [0060], [0061] *<br>* figure 2 * | 1-3, 5-10,12 | TECHNICAL FIELDS SEARCHED (IPC)<br><br>H01L<br>H05B<br>H01G<br>G02F |
| A | WO 2007/113259 A2 (PILKINGTON GROUP LTD [GB]; PILKINGTON ITALIA S P A [IT]; GAGLIARDI GIO) 11 October 2007 (2007-10-11)<br>* page 1, line 1 - page 2, line 6 *<br>* page 6, line 17 - page 8, line 6 *<br>* page 9, lines 8-11 * | 1-3,5, 7-11 | |

-/--

The present search report has been drawn up for all claims

| Place of search | Date of completion of the search | Examiner |
|---|---|---|
| Berlin | 1 July 2010 | Weis, Thomas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt
European
Patent Office
Office européen
des brevets

**EUROPEAN SEARCH REPORT**

Application Number

EP 09 38 2238

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GOSH D S ET AL: "Widely transparent electrodes based on ultrathin metals" OPTICS LETTERS, OSA, OPTICAL SOCIETY OF AMERICA, WASHINGTON, DC, US LNKD-DOI:10.1364/OL.34.000325, vol. 34, no. 3, 1 February 2009 (2009-02-01), pages 325-327, XP001521884 ISSN: 0146-9592 * the whole document * | 1-3,6,8 | |
| A | CHEN M S ET AL: "Ultrathin, ordered oxide films on metal surfaces" JOURNAL OF PHYSICS: CONDENSED MATTER, INSTITUTE OF PHYSICS PUBLISHING, BRISTOL, GB, vol. 20, no. 26, 2 July 2008 (2008-07-02), page 264013, XP020136003 ISSN: 0953-8984 * abstract * * par. 5 "Titania thin films"; par. 6 "Conclusions"; figures 12, 13 * | 1-3 | |
| A | DE 44 27 215 A1 (AGENCY IND SCIENCE TECHN [JP]) 23 February 1995 (1995-02-23) * column 1, line 27 - column 2, line 11 * * column 3, lines 21-45 * * column 4, lines 6-37 * | 1-3 | |
| A | US 4 345 107 A (FULOP GABOR F ET AL) 17 August 1982 (1982-08-17) * column 4, line 51 - column 5, line 2 * * column 8, lines 3-23 * * column 10, line 63 - column 11, line 2 * * figure * | 1,2,4 | |

TECHNICAL FIELDS
SEARCHED      (IPC)

-/--

The present search report has been drawn up for all claims

| Place of search | Date of completion of the search | Examiner |
|---|---|---|
| Berlin | 1 July 2010 | Weis, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt
European
Patent Office
Office européen
des brevets

**EUROPEAN SEARCH REPORT**

Application Number

EP 09 38 2238

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 555 695 A1 (SANYO ELECTRIC CO [JP]) 20 July 2005 (2005-07-20) * paragraphs [0002], [0003] * * figures 23,24 * ----- | 1,4,13 | |
| A | EP 1 453 117 A2 (SCHOTT GLAS [DE]; ZEISS CARL STIFTUNGTRADING AS [DE] SCHOTT AG [DE]) 1 September 2004 (2004-09-01) * paragraphs [0058] - [0060], [0094] * * figure 7A * ----- | 2,4,13 | |
| | | | **TECHNICAL FIELDS SEARCHED (IPC)** |

The present search report has been drawn up for all claims

| Place of search | Date of completion of the search | Examiner |
|---|---|---|
| Berlin | 1 July 2010 | Weis, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 09 38 2238

This annex lists the patent family members relating to the patent documents cited in the above-mentioned European search report.
The members are as contained in the European Patent Office EDP file on
The European Patent Office is in no way liable for these particulars which are merely given for the purpose of information.

01-07-2010

| Patent document cited in search report | | Publication date | Patent family member(s) | | Publication date |
|---|---|---|---|---|---|
| US 6184964 | B1 | 06-02-2001 | NONE | | |
| US 6825409 | B2 | 30-11-2004 | DE | 19958878 A1 | 28-06-2001 |
| | | | EP | 1151480 A1 | 07-11-2001 |
| | | | WO | 0143204 A1 | 14-06-2001 |
| | | | US | 2002179143 A1 | 05-12-2002 |
| US 2003165693 | A1 | 04-09-2003 | DE | 60318632 T2 | 15-01-2009 |
| | | | US | 2005191513 A1 | 01-09-2005 |
| | | | US | 2003165694 A1 | 04-09-2003 |
| | | | US | 2008268262 A1 | 30-10-2008 |
| WO 2007113259 | A2 | 11-10-2007 | CN | 101437771 A | 20-05-2009 |
| | | | EP | 2010459 A2 | 07-01-2009 |
| | | | JP | 2009531262 T | 03-09-2009 |
| | | | KR | 20080109899 A | 17-12-2008 |
| | | | US | 2009047509 A1 | 19-02-2009 |
| DE 4427215 | A1 | 23-02-1995 | FR | 2708626 A1 | 10-02-1995 |
| US 4345107 | A | 17-08-1982 | NONE | | |
| EP 1555695 | A1 | 20-07-2005 | CN | 1641888 A | 20-07-2005 |
| | | | US | 2005150543 A1 | 14-07-2005 |
| EP 1453117 | A2 | 01-09-2004 | CN | 1525583 A | 01-09-2004 |
| | | | DE | 10308515 A1 | 16-09-2004 |
| | | | EP | 1597781 A2 | 23-11-2005 |
| | | | WO | 2004076230 A2 | 10-09-2004 |
| | | | US | 2004164674 A1 | 26-08-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 08157959 A
- EP 09382079 A

**Non-patent literature cited in the description**

- **Claes G. Granqvist.** Transparent conductors as solar energy materials: A panoramic review. *Solar Energy Materials & Solar Cells,* 2007, vol. 91, 1529-1598
- **Ullrich Mitschke ; Peter BaÈuerle.** The electroluminescence of organic materials. *J. Mater. Chem.,* 2000, vol. 10, 1471
- **CM Lee et al.** Minimizing DC drift in LiNbO3 waveguide devices. *Applied Physics Lett.,* 1985, vol. 47, 211
- **C.A. Smith.** A review of liquid crystal display technologies, electronic interconnection and failure analysis Circuit. *World,* 2008, vol. 34 (1), 35-41
- **Yu-Zung Chiou ; Jing-Jou TANG.** GaN Photodetectors with Transparent Indium Tin Oxide Electrodes. *Japanese Journal of Applied Physics,* 2004, vol. 43 (7A), 4146-4149
- **K. Sivaramakrishnan et al.** *Applied Phys Lett.,* 2009, vol. 94, 052104
- **D.R. Sahu et al.** *Applied Surface Science,* 2006, vol. 253, 827-832
- **D.R. Sahu et al.** *Applied Surface Science,* 2006, vol. 253, 915-918
- **D.R. Sahu et al.** *Thin Solid Films,* 2007, vol. 516, 208-211
- **Tien-Chai Lin et al.** *Materials Science and Engineering,* 2008, vol. 129, 39-42
- **D.S. Gosh et al.** *Opt. Lett.,* 2009, vol. 34, 325
- **D. Krautz et al.** *Nanotechnology,* 2009, vol. 20, 275204